# EUROPEAN PATENT APPLICATION

(11) **EP 1 387 602 A1**
(43) Date of publication of application: **04.02.2004**
(21) Application number: 02425500.2
(22) Date of filing: 31.07.2002
(51) Int. Cl.: H05K 3/16, C23C 14/04, C23C 14/18

(54) **A method of forming an electrically conductive coating on support sheets for printed circuit cards**

(71) Applicant: Fox Technologies S.r.l., 20059 Vimercate (MI) (IT)
(72) Inventor: Ferri, Carlo, 21040 Carnago (VA) (IT)
(74) Representative: Tansini, Elio Fabrizio

(57) **Abstract**

A coating of conductive material (7) is formed by a sputtering process on at least one support sheet (3) of a printed-circuit card (1), and in particular at a through hole (6) bored through one or more coupled support sheets (3). The thickness of the conductive coating (7) can be increased by electroplating.

Also described is a process for making printed circuit cards in which the method in reference is employed.

## Description

The present invention relates to a method of applying a conductive coating to a support sheet of a printed circuit card. The present invention also relates to a process for manufacturing cards for printed circuits, comprising the steps set out in the preamble of claim 10.

It is known that cards for printed circuits comprise one or more circuit layers, each of them being made starting from a support sheet of dielectric material usually of the composite type, comprising glass fibres incorporated into a resin matrix, for example. Applied to at least one side of the support sheet, usually through gluing by hot-pressing, is an electrically conductive coating made of copper or other appropriate material, covered with a photosensitive protective resin on which, by a photographic process, the circuit pattern to be associated with the card is printed. The protective resin parts exposed to the light are adapted to resist the chemical agents contained in the developers subsequently employed to remove resin and copper from the regions unconcerned with the circuit pattern, i.e. unexposed to the light.

The conductive material protected by the light-exposed resin, once the resin has been removed by a further chemical process, forms the desired circuit pattern on the support sheet.

For accomplishment of a card for printed circuits, coupling of a plurality of circuit layers obtained as above described is often required. Cards for particularly complicated and advanced printed circuits may involve even 20 or more circuit layers each carrying a specific circuit pattern, which are mutually coupled in superposed relationship following a predetermined sequence and a precise positioning, after interposition of a layer of insulating material also causing mutual gluing of the layers through a hot-pressing step.

In circuit planning, formation of bridges for electrical connection between given tracks of the circuit patterns of a layer with the tracks of the circuit pattern set on at least one of the layers superposed thereon is often required.

Each connecting bridge is usually made by piercing a through hole through the mutually coupled circuit layers and at the tracks to be connected with each other, which hole is adapted to receive an electrically conductive element suitable to mutually connect the tracks.

In the methods of modern conception, these conductive connecting elements are obtained by carrying out an electroplating process adapted to form a layer of copper or other electrically conductive material on the inner walls of the hole. Before carrying out said electroplating, a preventive chemical treatment is however required which aims at depositing a layer of salts to make the surfaces of the through hole electrically conductive.

The preliminary chemical treatment and subsequent electroplating cause deposition of the salts and metal also on the card surfaces external to the through holes, which is usually accepted.

The Applicant has found that the above described known art has several drawbacks.

For example, the treatment aiming at depositing conductive salts needs accomplishment of many chemical baths during which a rigid control of the great number of process parameters is to be carried out, such as concentration of the active ingredients in the baths, treatment temperatures and times, for example. This involves use of sophisticated and complicated apparatus bringing about important economical investments and management costs.

In addition, use of chemical substances involves non negligible problems from the point of view of environmental pollution.

It should be also noted that known processes do not give rise to a steady anchoring of the metal coating to the surfaces of the composite material forming the support sheet, because deposition of the conductive salts may cause a lack of adhesion of the overlying metallic coating layer.

This bond may be considered as sufficiently strong on the inner surface of the holes made rough by mechanical removal of the material carried out during drilling, but is not sufficiently strong at the outer surfaces of the support sheet that are much smoother.

These circumstances lead to the necessity to make the conductive coating by application of a copper sheet through a hot-pressing process that cannot be used instead of the electroplating process which is necessarily carried out in order to obtain coating of the hole surfaces.

It should be also recognized that application of the conductive coating by hot pressing must be necessarily carried out before drilling, since the hole must compulsorily pass through the conductive coating too. The Applicant has found that this aspect too is disadvantageous because during the different handling operations provided in the production process, the conductive coating is exposed to accidental contacts with foreign elements that can damage it and/or impair a correct execution of the different working steps.

Carrying out the holes in the presence of the conductive coating uniformly applied to the support sheet involves further problems in terms of establishment of the correct positioning of the holes to be carried out. In fact the conductive coating conceals the optical references usually arranged on the individual layers to enable a correct mutual positioning of same. Therefore use of sophisticated X-ray taking apparatus is required, which will bring about problems in order to succeed in identifying the optical references present under the conductive coating.

In addition, possible mis-alignments in the holes or between the individual layers can be only detected after the excess conductive material has been removed following a photochemical treatment for obtaining the circuit pattern. Consequently, discarding of faulty articles of manufacture in an advanced step of the working cycle is made necessary, even when the defects therein present have been generated during an initial step of the working cycle.

It has been also found that traces of the chemical agents employed in the treatment preceding electroplating can remain attached to the interstices produced by the surface roughness of the material, above all at the through holes. This can give rise to structural damage of the card over time and also to malfunctions resulting from short-circuits due to diffusion of foreign substances by capillarity along the fibres forming the composite material of the support sheets.

In accordance with the present invention, the possibility has been perceived of overcoming the problems connected with the known working processes as well as of obtaining further unexpected advantages by making the electrically conductive coating with the aid of an ionic pulverizing treatment, usually referred to as sputtering, carried out on a mass of electrically conductive material in the vicinity of which the support sheet being worked is arranged.

In more detail, it is an object of the present invention to provide a method of forming an electrically conductive coating on support sheets for printed circuit cards, as defined in claim 1.

It is a further object of the invention to provide a process for making printed circuit cards as defined in claim 10.

Further features and advantages will become more apparent from the detailed description of a preferred but not exclusive embodiment of a method of forming an electrically conductive coating on support sheets for printed circuit cards and a process for making printed circuit cards utilizing said method, in accordance with the present invention. This description will be set out hereinafter with reference to the accompanying drawings, given by way of non-limiting example, in which:
- Fig. 1 is a diagrammatic view in section of a plurality of circuit layers to be mutually coupled in the context of a process for making a card for printed circuits, after interposition of respective insulating layers;
- Fig. 2 shows a process step subsequent to Fig. 1, in which the circuit layers have been mutually coupled;
- Fig. 3 shows a subsequent step in which a through hole has been bored through the circuit layers;
- Fig. 4 diagrammatically shows execution of an electrically conductive coating in accordance with the present invention;

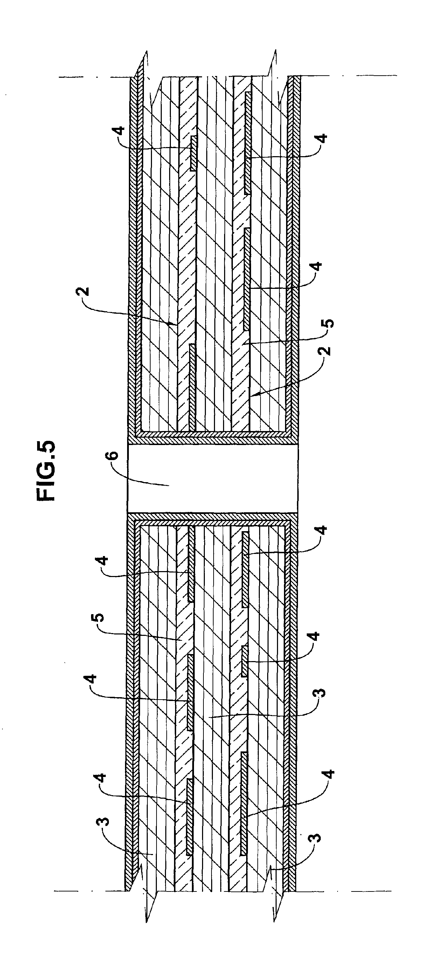

- Fig. 5 shows the coupled circuit layers after formation of the electrically conductive coating on the outer surfaces of the card and the inner surfaces of the through hole.

With reference to the drawings, a card for printed circuits to be obtained by a process and a method in accordance with the present invention has been generally identified by reference numeral 1.

In a manner known per se, card 1 is made by first forming one or more circuit layers 2 usually referred to as "inner layers", each comprising a support sheet 3 of dielectric material preferably of the composite type comprising glass fibres incorporated into a resin matrix for example; the support sheet 3 however can be made of at least one material selected from the group comprising glass fibres incorporated into a resinous matrix, polytetrafluoroethylene, thermosetting resin, polyimide resin.

Defined on at least one side of the support sheet 3 are tracks of conductive material 4 disposed in a predetermined circuit pattern or design.

As shown in the accompanying figures, use of several circuit layers 2 is usually provided, which layers are mutually coupled in superposed relationship, by a hot-pressing process for example, upon interposition of at least one insulating layer 5 of dielectric material also acting as a bonding agent to cause mutual fastening of the contiguous circuit layers. The tracks of conductive material 4 in each circuit layer 2 can be obtained by first forming an electrically conductive coating uniformly distributed on at least one side of the support sheet 3. Then the desired circuit pattern is defined on the electrically conductive coating, using normal photographic processes. Afterwards, removal of the excess conductive material not concerned with the circuit pattern is caused, so as to obtain tracks 4.

The tracks 4 belonging to circuit patterns of two distinct circuit layers 2 or disposed on two opposite sides of the same circuit layer 2 may be required to be electrically connected with each other. For the purpose accomplishment of a through hole 6 terminating at the tracks 4 to be mutually connected is provided, said hole 6 having an electrically conductive coating 7 on its inner surfaces which can also extend on at least one of the outer sides of card 1 to define the circuit pattern tracks 4 provided on said at least one outer side.

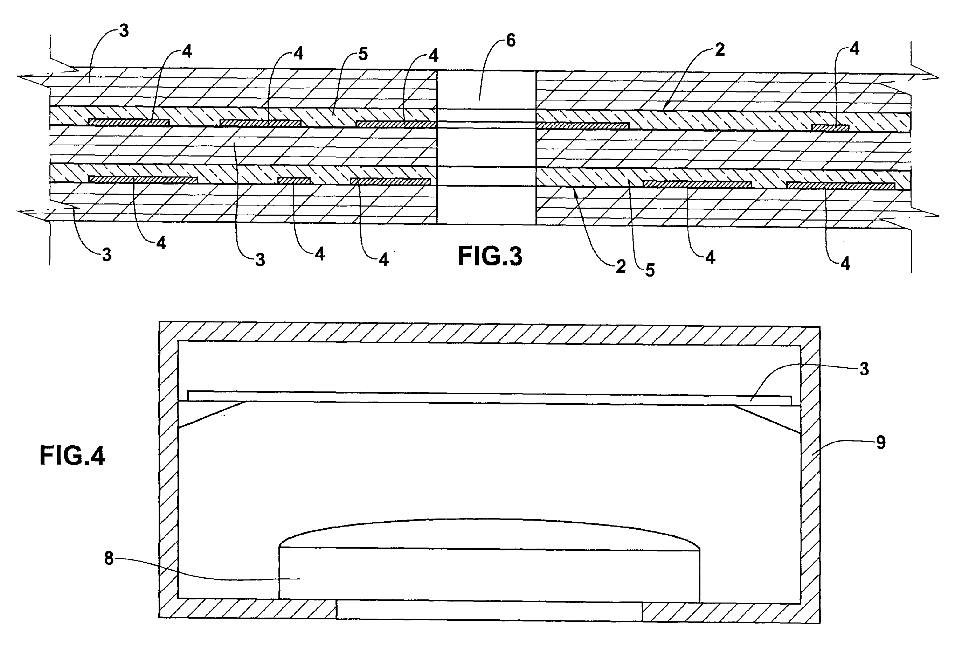

After the above statements, it is in principle provided, in accordance with the present invention, that the electrically conductive layer 7 designed to form the circuit tracks 4 on at least one of the support sheets 3 and/or to coat the walls of the through hole 6 should be made by a method according to which, as shown in Fig. 4, the card being processed or a single support sheet 3 is first positioned with at least one surface portion thereof to be coated facing a target mass 8 of electrically conductive material, copper for example. The target mass 8 is then partly pulverized by a ionic pulverizing treatment, better known as sputtering. In this treatment, usually employed in the processes for making semiconductors for example, essentially the support sheet 3 or card 1 being processed and the target mass 8 are provided to be placed in a treatment chamber 9 hermetically insulated from the external environment and containing an inert gas, argon for example, to a pressure greatly lower than the atmospheric pressure. With the aid of a magnetron preferably of the planar type, ionization of the gas is established the positively-charged atoms of which are attracted to the target mass 8 when the latter is connected to a negative electric potential. Alternatively, the magnetron can be fed from a radio-frequency electric source.

The gas atoms impinge on the target mass with a high impact energy thereby submitting it to a ionic bombardment causing separation of small fragments of electrically conductive material from the target mass. The electrically conductive material pulverized as above described is thrown into the treatment chamber and at least part of same hits the support sheet 3 or card being processed 1 on the upper portion thereof exposed to the target mass. In order to promote migration of the conductive-material particles to the support sheet 3 or the card 1 being processed, connection of the latter with a positive electric potential is carried out concurrently with the ionic bombardment.

By suitably modulating the sputtering treatment parameters, such as distance, shape and sizes of the target mass 8, gas pressure within the treatment chamber 9, value of the applied electric potentials, as well the residence time of same, the sputtering process can be managed in such a manner that distribution of fine particles of conductive material intimately joined to the surface of the support sheet 3 and to each other is obtained in order to form a layer of controlled thickness.

An electroplating process can be subsequently put into practice to determine application of an additional layer 7a of conductive material superposed on a substrate 7b previously obtained by the sputtering treatment so as to form the conductive layer 7 together with said substrate. Application of the conductive layer 7 by the above described method can be carried out on at least one of the sides of each of the support sheets 3, before mutual coupling of same, and/or on the inner walls of the through hole or holes 6 of already formed circuit layers 2.

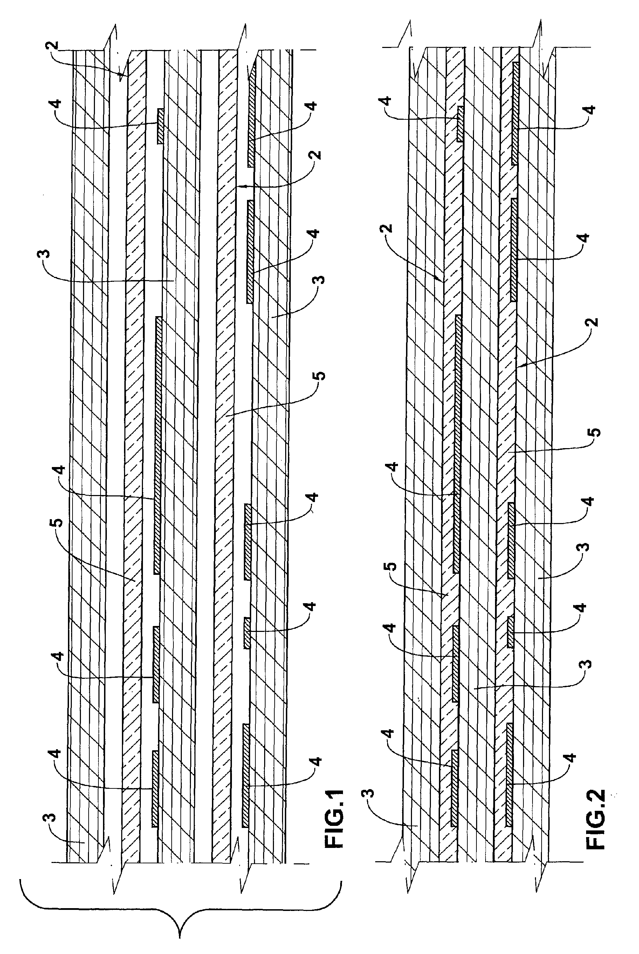

In the particular embodiment referred to in the figures, there is shown use of the method in accordance with the invention for application of the conductive coating 7 to the inner walls of the through hole 6 and to one of the sides of each of the support sheets 3 defining the outer surfaces of the card 1 being processed. In particular, as shown in Fig. 1, two circuit layers 2 previously formed are provided to be coupled with each other and with a support sheet 3 being part of a third circuit layer 2 that is to be still completed. When coupling is over, the tracks 4 of the finished circuit layers 2 are enclosed between the respective support sheet 3 and the adjacent insulating layer 5, as shown in Fig. 2.

As viewed from Fig. 3, the through hole 6 is then formed and arranged to carry out the electric connection between the tracks of the circuit patterns that are still to be made on the externally facing surfaces of the first and last support sheets 3.

Through accomplishment of the coating method by the above described sputtering treatment and possibly subsequent electroplating, formation of the coating layer that initially will uniformly coat the outer sides of the support sheets 3, is carried out. Application of coating 7 on each of the opposite support sheets 3 can be obtained, if necessary, by repeating the sputtering treatment twice in succession.

Afterwards, the desired circuit patterns can be made on each of the outer sides of card 1, by removal of the excess material from the coating layer 7 with the aid of usual photoengraving processes.

If required, accomplishment of card 1 may involve superposition and coupling of further circuit layers.

The present invention achieves the intended purposes.

Formation of the conductive coating by the method in reference in fact enables elimination of all problems connected with the execution of the preliminary chemical treatments necessary in the known art for carrying out the subsequent electroplating operation.

In particular, if required, the invention enables the electroplating operation to be directly carried out on the metal substrate obtained by the sputtering treatment.

It has been found that the sputtering treatment gives rise to a very intimate union of the metal particles on the surfaces of the support sheet, ensuring an efficient anchoring even on smooth surfaces, such as those usually present on the opposite sides of the support sheets.

In addition, application of the conductive material without use of chemical agents eliminates all problems arising in the known art when chemical substances or traces of same keep bound to the fibres of the composite material constituting the support sheets. The concerned method therefore enables a great increase in the operating liability of the cards, which is one of the most important problems connected with use of electronics.

The method of the invention also enables the boring operations to be carried out in the absence of metal coatings on the outer surfaces of the card being processed, so that an easy control of the hole position is allowed and also of the mutual positioning of the circuit patterns in the different layers, that are optically detectable by looking through the support sheets against the light without the aid of X-ray apparatus of high cost and complicated management.

Another advantageous aspect of the present invention resides in its being fully compatible and associable with normal processes for application of the coating through hot-pressing systems. In fact, the concerned method can be indifferently used to form the conductive coating on all or only some of the card parts, without precluding the possibility of applying the conductive coatings by hot-pressing on the sides of the support sheets 3 forming the inner layers of the card.

## Claims

1. A method of forming an electrically conductive coating on support sheets of printed circuit cards, **characterized in that** it comprises the following steps:
- positioning at least one support sheet (3) with at least one surface portion thereof to be coated facing a target mass (8) of electrically conductive material;
- pulverizing the target mass (8) by a sputtering treatment.

2. A method as claimed in claim 1, wherein the pulverizing operation includes the steps of submitting the target mass (8) to ionic bombardment and throwing particles of conductive material separated from the target mass (8) by effect of the ionic bombardment, against the surface portion of the support sheet (3).

3. A method as claimed in claim 2, wherein pulverizing of the target mass (8) is carried out in a treatment chamber (9) hermetically insulated from the external environment and containing an ionized gas, said ionic bombardment being carried out by applying a negative electric potential to the target mass (8).

4. A method as claimed in claim 2, wherein a positive electric potential is applied to the support sheet (3) concurrently with the ionic-bombardment step.

5. A method as claimed in claim 2, wherein pulverizing of the target mass (8) is carried out in a treatment chamber (9) hermetically insulated from the external environment and containing an ionized gas, said ionic bombardment being carried out with the aid of a magnetron fed from a radio-frequency electric source.

6. A method as claimed in claim 1, wherein said support sheet (3) is submitted to an electroplating treatment to apply an additional layer (7a) of conductive material superposed on a substrate (7b) previously formed by a sputtering treatment.

7. A method as claimed in claim 1, wherein the support sheet (3) is made of a composite material.

8. A method as claimed in claim 1, wherein the support sheet (3) is made of at least one material selected from the group comprising glass fibres incorporated in a resinous matrix, polytetrafluoroethylene, thermosetting resin, polyimide resin.

9. A method as claimed in claim 1, wherein the target mass (8) is made of copper.

10. A method as claimed in claim 1, wherein said surface portion extends on the walls of at least one through hole (6) formed in the support sheet (3).

11. A method as claimed in claim 1, wherein the surface portion extends on at least one side of the support sheet (3).

12. A process for making cards for printed circuits, comprising accomplishment of at least one circuit layer by the steps of:
- forming an electrically conductive coating (7) on a support sheet (3) of dielectric material;
- defining a circuit pattern (4) on the conductive coating (7);
- removing portions of the conductive coating (7) not concerned with the circuit pattern (4) from the support sheet (3),
**characterized in that** formation of the conductive coating (7) is at least partly carried out by a method as claimed in one or more of the preceding claims.

13. A process as claimed in claim 12, further comprising the step of making at least one through hole (6) in the support sheet (3) prior to formation of the conductive coating (7) at least at the inner walls of the through hole (6).

14. A process as claimed in claim 13, wherein the electrically conductive coating (7) is simultaneously formed on the inner walls of said at least on through hole (6) and on at least on side of the support sheet (3) .

15. A process as claimed in claim 13, wherein before the boring step the support sheet (3) is coupled with at least one previously-formed circuit layer (2), said at least one through hole (6) being formed through the support sheet (3) and the circuit layer coupled therewith.
